# EUROPÄISCHE PATENTSCHRIFT

(11) **EP 1 709 694 B1**
(45) Veröffentlichungstag und Bekanntmachung des Hinweises auf die Patenterteilung: **15.03.2017**
(21) Anmeldenummer: 05706695.3
(22) Anmeldetag: 25.01.2005
(51) Int. Cl.: H01L 33/14, H01L 33/32, H01L 33/38, H01L 33/40

(54) **DÜNNFILM-LED MIT EINER STROMAUFWEITUNGSSTRUKTUR**
THIN-FILM LED COMPRISING A CURRENT-DISPERSING STRUCTURE
DEL A FILM MINCE AYANT UNE STRUCTURE D'ELARGISSEMENT DE COURANT

(30) Priorität: 26.01.2004 DE 102004003986
(43) Veröffentlichungstag der Anmeldung: 11.10.2006
(73) Patentinhaber: OSRAM Opto Semiconductors GmbH, 93055 Regensburg (DE)
(72) Erfinder: BAUR, Johannes, 93164 Laaber (DE); HAHN, Berthold, 93155 Hemau (DE); HÄRLE, Volker, 93164 Laaber (DE); OBERSCHMID, Raimund, 93161 Sinzing (DE); WEIMAR, Andreas, 93055 Regensburg (DE)
(74) Vertreter: Epping - Hermann - Fischer
(86) Internationale Anmeldenummer: PCT/DE2005/000099
(87) Internationale Veröffentlichungsnummer: WO 2005/071763

(56) Entgegenhaltungen:
- US-A- 5 744 828
- US-A- 5 861 636
- US-A1- 2003 209 717
- US-A1- 2004 004 223
- US-B1- 6 541 797
- ALGORA C: "LARGE-AREA INFRARED-EMITTING DIODES WITH AN OUTPUT OPTICAL POWER GREATER THAN 1 W" IEEE PHOTONICS TECHNOLOGY LETTERS, IEEE SERVICE CENTER, PISCATAWAY, NJ, US, Bd. 10, Nr. 3, März 1998 (1998-03), Seiten 331-333, XP000740665 ISSN: 1041-1135
- JONES BEY: 'Indium nitride bandgap energy is revealed.' LASER FOCUS Bd. 39, Nr. 1, 01 Januar 2003, XP055077849 ISSN: 0740-2511

## Beschreibung

Die Erfindung betrifft einen Dünnfilm-LED nach dem Oberbegriff des Patentanspruchs 1.

Diese Patentanmeldung beansprucht die Priorität der deutschen Patentanmeldung 10 2004 003 986.0, deren Offenbarungsgehalt hiermit durch Rückbezug aufgenommen wird.

Die Druckschrift US 6,541,797 B1 beschreibt eine LED, die Nitridverbindungshalbleitermaterialien aufweist.

Ein bekanntes Verfahren zur Herstellung optoelektronischer Bauelemente, insbesondere zur Herstellung von Lumineszenzdioden auf der Basis von Nitridverbindungshalbleitern, basiert auf der sogenannten Dünnfilm-Technologie. Bei diesem Verfahren wird eine funktionelle Halbleiterschichtenfolge, die insbesondere eine strahlungsemittierende aktive Schicht umfasst, zunächst epitaktisch auf einem Aufwachssubstrat aufgewachsen, anschließend ein neuer Träger auf die dem Aufwachssubstrat gegenüber liegende Oberfläche der Halbleiterschichtenfolge aufgebracht und nachfolgend das Aufwachssubstrat abgetrennt. Da die für Nitridverbindungshalbleiter verwendeten Aufwachssubstrate, beispielsweise SiC, Saphir oder GaN vergleichsweise teuer sind, bietet dieses Verfahren insbesondere den Vorteil, dass das Aufwachssubstrat wiederverwertbar ist. Das Ablösen eines Aufwachssubstrats aus Saphir von einer Halbleiterschichtenfolge aus einem Nitridverbindungshalbleiter kann beispielsweise mit einem aus der WO 98/14986 bekanntem Laser-Lift-Off-Verfahren erfolgen.

Eine Dünnfilm-LED zeichnet sich insbesondere durch folgende charakteristische Merkmale aus:
- an einer zu einem Träger hin gewandten Hauptfläche einer strahlungserzeugenden Epitaxieschichtenfolge ist eine reflektierende Schicht (Spiegelschicht) aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20µm oder weniger, insbesondere im Bereich von etwa 6 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip einer Dünnfilm-LED ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Die elektrische Kontaktierung von Dünnfilm-LEDs erfolgt in der Regel durch zwei elektrische Kontaktschichten, beispielsweise durch eine p-Kontaktschicht auf der Rückseite des Trägers und eine n-Kontaktschicht auf der vom Träger abgewandten Seite der Halbleiterschichtenfolge. In der Regel ist die vom Träger abgewandte Seite der Dünnfilm-LED zur Strahlungsauskopplung vorgesehen, so dass eine für die emittierte Strahlung nicht-transparente Kontaktschicht nur auf einen Teilbereich der Oberfläche der Halbleiterschichtenfolge aufgebracht werden kann. Aus diesem Grund wird oftmals nur ein vergleichsweise kleiner zentraler Bereich der Chipoberfläche mit einer Kontaktfläche (Bondpad) versehen.

Bei herkömmlichen Lumineszenzdiodenchips, die eine Kantenlänge von weniger als 300 µm aufweisen, kann in der Regel bereits mit einem zentral auf der Chipoberfläche angeordneten Bondpad eine vergleichsweise homogene Stromverteilung im Halbleiterchip erreicht werden. Bei großflächigen Halbleiterchips, die beispielsweise eine Kantenlänge von etwa 1 mm aufweisen, kann diese Art der Kontaktierung aber nachteilig zu einer inhomogenen Bestromung des Halbleiterchips führen, die zu einer erhöhten Vorwärtsspannung und zu einer geringeren Quanteneffizienz in der aktiven Zone führt. Dieser Effekt tritt insbesondere bei Halbleitermaterialien, die eine geringe Querleitfähigkeit aufweisen, insbesondere bei Nitridverbindungshalbleitern, auf. Die maximale Stromdichte tritt in diesem Fall in einem zentralen Bereich des Halbleiterchips auf. Die in diesem zentralen Bereich des Halbleiterchips emittierte Strahlung wird aber zumindest teilweise zu dem nicht transparenten Bondpad hin emittiert und somit zumindest teilweise absorbiert.

Um die Stromaufweitung zu verbessern, ist beispielsweise bekannt, eine dünne semitransparente Metallisierungsschicht, zum Beispiel Pt oder NiAu, ganzflächig auf die Chipoberfläche eines p-Halbleitermaterials aufzubringen. Dabei wird jedoch ein nicht vernachlässigbarer Teil der emittierten Strahlung, beispielsweise etwa 50%, in der semitransparenten Schicht absorbiert. Weiterhin sind derartige Kontaktschichten nicht ohne weiteres zur Kontaktierung von n-dotierten Nitridverbindungshalbleitern geeignet.

Zur Verbesserung der Stromeinkopplung bei InGaAlP-LEDs ist aus der DE 199 47 030 A1 bekannt, eine relativ dicke, transparente Stromaufweitungsschicht, die mit einer lateral strukturierten elektrischen Kontaktschicht versehen ist, zu verwenden. Die Stromeinprägung erfolgt dabei durch ein zentrales Bondpad sowie durch mehrere mit dem Bondpad verbundene Kontaktstege auf der Chipoberfläche. Diese Art der Kontaktierung ist nicht ohne weiteres auf großflächige Leuchtdiodenchips, die ein Halbleitermaterial mit geringer Querleitfähigkeit, insbesondere Nitridverbindungshalbleiter, enthalten, übertragbar, da die Dichte der nicht-transparenten Kontaktstege auf der Chipoberfläche derart erhöht werden müsste, dass ein Großteil der emittierten Strahlung in der Kontaktschicht absorbiert würde. Eine vergleichsweise dicke Stromaufweitungsschicht führt ferner zu einem erhöhten Spannungsabfall und beansprucht eine lange Wachstumszeit bei der Herstellung. Ferner können in einer vergleichsweise dicken Stromaufweitungsschicht Verspannungen auftreten, durch die möglicherweise Risse induziert werden können.

Der Erfindung liegt die Aufgabe zugrunde, eine Dünnfilm-LED mit einer verbesserten Stromaufweitungsstruktur anzugeben, die sich insbesondere durch eine vergleichsweise homogene Stromverteilung über die Chipfläche bei einer vergleichsweise geringen Abschattung der Chipoberfläche durch Kontaktschichtmaterial auszeichnet.

Diese Aufgabe wird durch einen Dünnfilm-LED mit den Merkmalen des Patentanspruchs 1 gelöst. Vorteilhafte Ausgestaltungen und Weiterbildungen der Erfindung sind Gegenstand der abhängigen Ansprüche.

Bei einer Dünnfilm-LED mit einer aktiven Schicht, die elektromagnetische Strahlung in eine Hauptstrahlungsrichtung emittiert, einer der aktiven Schicht in der Hauptstrahlungsrichtung nachfolgenden Stromaufweitungsschicht aus einem ersten Nitridverbindungshalbleitermaterial, einer Hauptfläche, durch welche die in der Hauptstrahlungsrichtung emittierte Strahlung ausgekoppelt wird, und einer ersten Kontaktschicht, die auf der Hauptfläche angeordnet ist, ist gemäß der Erfindung die Querleitfähigkeit der Stromaufweitungsschicht durch Ausbildung eines zweidimensionalen Elektronengases erhöht.

Die erhöhte Querleitfähigkeit der Stromaufweitungsschicht führt zu einer homogenen Bestromung der aktiven Schicht und erhöht dadurch die Effizienz der Dünnfilm-LED.

Zur Ausbildung eines zweidimensionalen Elektronengases in der Stromaufweitungsschicht ist mindestens eine Schicht aus einem zweiten Nitridverbindungshalbleitermaterial, das eine größere elektronische Bandlücke als das erste Nitridverbindungshalbleitermaterial aufweist, in die Stromaufweitungsschicht eingebettet.

Das erste Nitridverbindungshalbleitermaterial und das zweite Nitridverbindungshalbleitermaterial weisen vorteilhaft jeweils die Zusammensetzung InₓAl_{y}Ga_{1-x-y}N mit 0 ≤ x ≤ 1, 0 ≤ y ≤ 1 und x + y ≤ 1 auf, wobei sich die Zusammensetzung des zweiten Nitridverbindungshalbleitermaterials von der Zusammensetzung des ersten Nitridverbindungshalbleitermaterials derart unterscheidet, dass die elektronische Bandlücke des zweiten Nitridverbindungshalbleitermaterials größer ist als die des ersten Nitridverbindungshalbleitermaterials. Dabei muss das jeweilige Material nicht zwingend eine mathematisch exakte Zusammensetzung nach obiger Formel aufweisen. Vielmehr kann es einen oder mehrere Dotierstoffe sowie zusätzliche Bestandteile aufweisen, die die physikalischen Eigenschaften des Materials im wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

An den Grenzflächen zwischen der mindestens einen Schicht aus dem zweiten Nitridverbindungshalbleitermaterial und der Stromaufweitungsschicht aus dem ersten Nitridverbindungshalbleitermaterial bilden sich Bereiche mit besonders hoher Querleitfähigkeit aus. Die erhöhte Querleitfähigkeit dieser Bereiche lässt sich im Bändermodell derart erklären, dass an den Grenzflächen zwischen dem ersten Nitridverbindungshalbleitermaterial und dem zweiten Nitridverbindungshalbleitermaterial jeweils eine Verbiegung der Bandkanten des Leitungsbandes und des Valenzbandes auftritt, die zur Ausbildung einer Potentialmulde führt, in der ein zweidimensionales Elektronengas mit besonders hoher Querleitfähigkeit auftritt.

Bei einer bevorzugten Ausführungsform einer Dünnfilm-LED gemäß der Erfindung sind mehrere Schichten aus dem zweiten Nitridverbindungshalbleitermaterial in die Stromaufweitungsschicht eingebettet. Auf diese Weise wird vorteilhaft eine Vielzahl von Grenzflächen zwischen dem ersten Nitridverbindungshalbleitermaterial und dem zweiten Nitridverbindungshalbleitermaterial ausgebildet, an denen sich aufgrund der Bandverbiegung jeweils eine Potentialmulde ausbildet, in der ein zweidimensionales Elektronengas mit hoher Querleitfähigkeit auftritt. Die Querleitfähigkeit der gesamten Stromaufweitungsschicht wird dadurch im Vergleich zu einer Stromaufweitungsschicht mit nur einer eingebetteten Schicht, die eine größere elektronische Bandlücke erste Nitridverbindungshalbleitermaterial aufweist, weiter erhöht. Die Anzahl der Schichten aus dem zweiten Nitridverbindungshalbleitermaterial beträgt vorzugsweise zwischen einschließlich 1 und 5.

Die Dicke der mindestens einen Schicht aus dem zweiten Nitridverbindungshalbleitermaterial beträgt beispielsweise etwa 10 nm bis 100 nm.

Das erste Nitridverbindungshalbleitermaterial, aus dem die Stromaufweitungsschicht gebildet ist, ist vorzugsweise GaN. Das zweite Nitridverbindungshalbleitermaterial ist beispielsweise AlₓGa₁₋ₓN mit 0 < x ≤ 1, wobei vorzugsweise 0,1 ≤ x ≤ 0,2 gilt.

Die mindestens eine Schicht aus dem zweiten Nitridverbindungshalbleitermaterial weist eine Dotierung auf, wobei eine Dotierstoffkonzentration in den an die Stromaufweitungsschicht angrenzenden Bereichen höher ist als in einem zentralen Bereich der Schicht. Die erhöhte Dotierstoffkonzentration in den an die Stromaufweitungsschicht angrenzenden Bereichen des zweiten Nitridverbindungshalbleitermaterials hat den Vorteil, dass in den Bereichen, in denen die Querleitfähigkeit durch die Ausbildung eines zweidimensionalen Elektronengases erhöht ist, eine erhöhte Anzahl an freien Ladungsträgern vorhanden ist. Die Querleitfähigkeit und die Stromaufweitung werden dadurch weiter verbessert.

Das erste und das zweite Nitridverbindungshalbleitermaterial sind jeweils n-dotiert. Es bildet sich ein zweidimensionales Elektronengas an den Grenzflächen zwischen dem ersten und dem zweiten Nitridverbindungshalbleitermaterial aus.

Die aktive Schicht der Dünnfilm-LED umfasst beispielsweise InₓAl_{y}Ga_{1-x-y}N mit 0 ≤ x ≤ 1, 0 ≤ y ≤ 1 und x + y ≤ 1. Die aktive Schicht kann zum Beispiel als Heterostruktur, Doppelheterostruktur oder als Quantentopfstruktur ausgebildet sein. Die Bezeichnung Quantentopfstruktur umfasst dabei jegliche Struktur, bei der Ladungsträger durch Einschluss (Confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Bei einer Ausführungsform der Dünnfilm-LED beträgt zumindest eine Kantenlänge der zur Strahlungsauskopplung vorgesehenen Hauptfläche 400 µm oder mehr, besonders bevorzugt 800 µm oder mehr. Insbesondere kann sogar eine Kantenlänge vom 1 mm oder mehr vorgesehen sein, wobei die Hauptfläche insbesondere eine quadratische Form aufweisen kann. Durch die Erhöhung der Querleitfähigkeit der Stromaufweitungsschicht kann selbst bei großflächigen Dünnfilm-LEDs eine vergleichsweise homogene Stromverteilung in der aktiven Schicht erzielt werden, die ansonsten mit einer herkömmlichen Stromaufweitungsschicht aus einem Nitridverbindungshalbleitermaterial nicht ohne weiteres zu realisieren wäre.

Die erste Kontaktschicht der Dünnfilm-LED, die auf der zur Strahlungsauskopplung vorgesehenen Hauptfläche angeordnet ist, enthält vorzugsweise ein Metall oder eine Metalllegierung. Vorzugsweise ist die erste Kontaktschicht eine Ti-Pt-Au-Schichtenfolge, die ausgehend von der angrenzenden Nitridverbindungshalbleiterschicht zum Beispiel eine etwa 50 nm dicke Ti-Schicht, eine etwa 50 nm dicke Pt-Schicht und eine etwa 2 µm dicke Au-Schicht umfasst. Eine Ti-Pt-Au-Schichtenfolge ist vorteilhaft unempfindlich gegenüber Elektromigration, die ansonsten, beispielsweise bei einer Aluminium enthaltenden ersten Kontaktschicht, auftreten könnte. Die erste Kontaktschicht ist daher bevorzugt frei von Aluminium.

Vorteilhaft weist die erste Kontaktschicht sie eine laterale Struktur auf, die eine Kontaktfläche (Bondpad) und mehrere Kontaktstege umfasst. Bei einer bevorzugten Ausführungsform ist die Kontaktfläche von mindestens einem rahmenförmigen Kontaktsteg umgeben, wobei der rahmenförmige Kontaktsteg durch mindestens einen weiteren Kontaktsteg mit der Kontaktfläche verbunden ist. Der mindestens eine rahmenförmige Kontaktsteg kann beispielsweise eine quadratische, rechteckige oder kreisförmige Form aufweisen.

Aufgrund der erhöhten Querleitfähigkeit der Stromaufweitungsschicht muss bei einer Dünnfilm-LED gemäß der Erfindung vorteilhaft nur ein vergleichsweise geringer Anteil der Hauptfläche von der Kontaktschicht bedeckt sein. Vorteilhaft sind nur weniger als 15%, besonders bevorzugt weniger als 10% Gesamtfläche der Hauptfläche von der ersten Kontaktschicht bedeckt. Die gute Querleitfähigkeit der Stromaufweitungsschicht hat weiterhin der Vorteil, dass bereits eine vergleichsweise grobe Strukturierung der Kontaktschicht ausreicht, um eine vergleichsweise homogene Stromdichteverteilung in der aktiven Schicht in der Dünnfilm-LED zu erzeugen. Vorteilhaft ist beispielsweise die Kontaktfläche von 1, 2 oder 3 rahmenförmigen Kontaktstegen umgeben. Eine feinere Strukturierung der Kontaktschicht, insbesondere die Verwendung einer größeren Anzahl von rahmenförmigen Kontaktstegen, ist zur Steigerung der Effizienz der Dünnfilm-LED aufgrund der hohen Querleitfähigkeit der Stromaufweitungsschicht nicht erforderlich. Der Aufwand für die Strukturierung der ersten Kontaktschicht ist deshalb vorteilhaft gering.

Eine weitere bevorzugte Ausführungsform enthält eine zweite Kontaktschicht, die von der aktiven Schicht aus gesehen der ersten Kontaktschicht gegenüberliegt. Die zweite Kontaktschicht weist in einem der Kontaktfläche gegenüberliegenden Bereich eine Aussparung auf. Die zweite Kontaktschicht ist also derart strukturiert, dass der Kontaktfläche, die zusammen mit mindestens einem Kontaktsteg die erste Kontaktschicht ausbildet, von der aktiven Schicht aus gesehen ein nicht von der zweiten Kontaktschicht bedeckter Bereich gegenüber liegt. Dies hat den Vorteil, dass die Stromdichte in einem Bereich der aktiven Schicht, der unterhalb der Kontaktfläche liegt, vermindert ist. Dies ist insbesondere vorteilhaft, wenn die erste Kontaktschicht aus einem nicht-transparenten Metall besteht, weil ansonsten zumindest ein Teil der unterhalb der Kontaktfläche erzeugten Strahlung in der Kontaktfläche absorbiert würde. Die Effizienz der Dünnfilm-LED wird auf diese Weise vorteilhaft erhöht.

Die zweite Kontaktschicht ist vorzugsweise eine für die emittierte Strahlung reflektierende Schicht. Dies ist insbesondere dann vorteilhaft, wenn die Dünnfilm-LED an einer der Hauptfläche gegenüberliegenden Fläche mit einer Verbindungsschicht, beispielweise einer Lotschicht, mit einem Träger verbunden ist. In diesem Fall wird die in Richtung des Trägers emittierte Strahlung von der reflektierenden Kontaktschicht zur Hauptfläche hin zurückreflektiert und auf diese Weise die Strahlungsabsorption im Träger und/oder der Verbindungsschicht vermindert.

Besonders vorteilhaft ist die Erfindung für Dünnfilm-LEDs, die mit einer Stromstärke von 300 mA oder mehr betrieben werden, da bei derart hohen Betriebsstromstärken bei herkömmlichen Dünnfilm-LEDs eine inhomogene Stromverteilung, die ein Maximum in einem zentralen Bereich des Leuchtdiodenchips aufweisen würde, zu beobachten wäre.

Die Erfindung wird im folgenden anhand von Ausführungsbeispielen und Vergleichsbeispielen im Zusammenhang mit den Figuren 1 bis 7 näher erläutert.

Es zeigen:
Figur 1A eine schematische Darstellung eines Querschnitts durch eine Dünnfilm-LED gemäß einem ersten Ausführungsbeispiel der Erfindung,
Figur 1B eine schematische Darstellung einer Aufsicht auf die Dünnfilm-LED gemäß dem ersten Ausführungsbeispiel der Erfindung,
Figur 2A eine schematische Darstellung eines Querschnitts durch eine Dünnfilm-LED gemäß einem zweiten Ausführungsbeispiel der Erfindung,
Figur 2B eine schematische Darstellung einer Aufsicht auf die Dünnfilm-LED gemäß dem zweiten Ausführungsbeispiel der Erfindung,
Figuren 3A und 3B eine schematische Darstellung der elektronischen Bandstruktur einer n-dotierten Halbleiterschicht, in die eine n-dotierte Schicht mit größerer elektronischer Bandlücke aus einem zweiten Halbleitermaterial eingebettet ist,
Figur 4 eine schematische Darstellung des Verlaufs der Dotierstoffkonzentration der in Figur 2 dargestellten Halbleiterschichten,
Figur 5 eine schematische Darstellung des Bändermodells einer Halbleiterschicht, in die mehrere Halbleiterschichten aus einem zweiten Halbleitermaterial mit größerer elektronischer Bandlücke eingebettet sind,
Figur 6 eine schematische Darstellung des Verlaufs der Valenzbandkante einer p-dotierten Halbleiterschicht, in die eine p-dotierte Halbleiterschicht aus einem zweiten Halbleitermaterial mit größerer elektronischer Bandlücke eingebettet ist, und
Figuren 7A und 7B eine schematische Darstellung des Bändermodells einer p-dotierten Halbleiterschicht, in die eine n-dotierte Halbleiterschicht aus einem zweiten

Halbleitermaterial mit größerer elektronischer Bandlücke eingebettet ist.

Gleiche oder gleichwirkende Elemente sind in den Figuren mit den gleichen Bezugszeichen versehen.

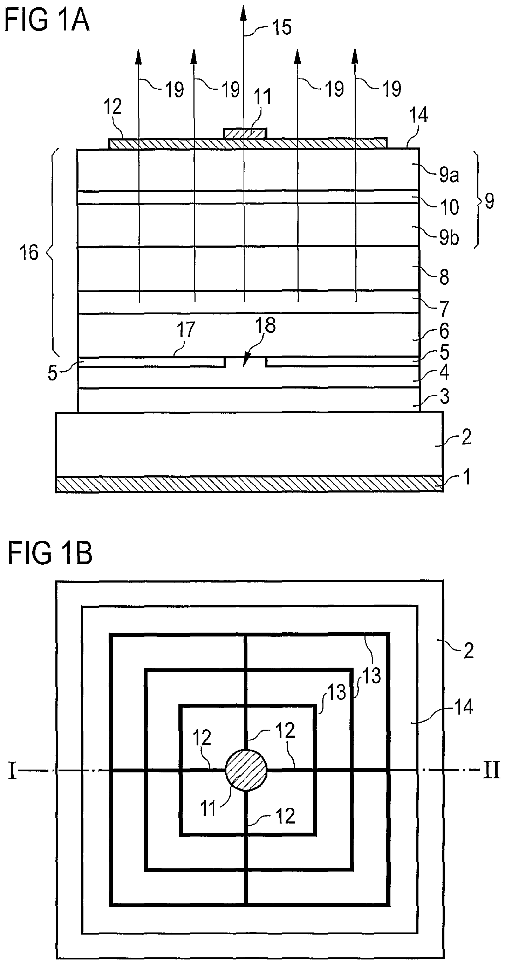

Die in der Figur 1A entlang einem Querschnitt der Linie I-II der in der Figur 1B gezeigten Aufsicht dargestellte Dünnfilm-LED gemäß einem ersten Ausführungsbeispiel der Erfindung enthält eine Epitaxieschichtenfolge 16, die eine aktive Schicht 7 umfasst. Die aktive Schicht 7 ist beispielsweise als Heterostruktur, Doppelheterostruktur oder als Quantentopfstruktur ausgebildet. Von der aktiven Schicht 7 wird elektromagnetische Strahlung 19, beispielsweise im ultravioletten, blauen oder grünen Spektralbereich, in eine Hauptstrahlungsrichtung 15 emittiert. Die aktive Schicht 7 ist beispielsweise zwischen mindestens einer p-dotierten Halbleiterschicht 6 und mindestens einer n-dotierten Halbleiterschicht 8 enthalten. Die von der aktiven Schicht 7 in die Hauptstrahlungsrichtung 15 emittierte elektromagnetische Strahlung 19 wird durch eine Hauptfläche 14 aus der Dünnfilm-LED ausgekoppelt.

Auf einer der Hauptfläche 14 gegenüberliegenden Seite ist die Epitaxieschichtenfolge 16 mittels einer Verbindungsschicht 3, beispielsweise einer Lotschicht, auf einem Träger 2 befestigt. Die Rückseite des Trägers ist beispielsweise mit einer Elektrode 1 versehen.

Zur elektrischen Kontaktierung der Epitaxieschichtenfolge 16 der Dünnfilm-LED ist eine erste Kontaktschicht 11, 12, 13 auf der Hauptfläche 14 der Dünnfilm-LED vorgesehen. Zwischen der aktiven Schicht 7 und der ersten Kontaktschicht 11, 12, 13 ist eine Stromaufweitungsschicht 9 enthalten, die ein erstes Nitridverbindungshalbleitermaterial, vorzugsweise GaN, enthält. In die Stromaufweitungsschicht 9 aus dem ersten Nitridverbindungshalbleitermaterial ist mindestens eine Schicht 10 aus einem zweiten Nitridverbindungshalbleitermaterial, vorzugsweise aus AlGaN, eingebettet, d.h. die Stromaufweitungsschicht 9 ist eine mehrlagige Schicht, die zum Beispiel zwei GaN-Teilschichten 9a, 9b, die durch eine eingebettete AlGaN-Schicht 10 voneinander getrennt sind, umfasst. Die AlGaN-Schicht 10 weist vorzugsweise die Zusammensetzung AlₓGa₁₋ₓN mit 0,1 ≤ x ≤ 0,2 auf.

Wie im folgenden noch näher erläutert wird, wird durch die in die Stromaufweitungsschicht 9 eingebettete Halbleiterschicht 10 die Querleitfähigkeit der Stromaufweitungsschicht 9 verbessert. Die in die Stromaufweitungsschicht 9 eingebettete Schicht 10 aus dem zweiten Nitridverbindungshalbleitermaterial weist bevorzugt eine Dicke von einschließlich 10 nm bis einschließlich 100 nm auf.

Der erste Kontaktschicht 11, 12, 13 umfasst bevorzugt eine Ti-Pt-Au-Schichtenfolge (nicht dargestellt), die ausgehend von der angrenzenden Stromaufweitungsschicht 10 zum Beispiel eine etwa 50 nm dicke Ti-Schicht, eine etwa 50 nm dicke Pt-Schicht und eine etwa 2 µm dicke Au-Schicht umfasst. Zur Vermeidung von Elektromigration enthält die erste Kontaktschicht 11, 12, 13 vorzugsweise kein Aluminium. Die laterale Struktur der auf der Hauptfläche 14 der Dünnfilm-LED angeordneten ersten Kontaktschicht 11, 12, 13 wird in der in Figur 1B dargestellten Aufsicht verdeutlicht. Die erste Kontaktschicht umfasst eine Kontaktfläche 11, die in einem zentralen Bereich der Hauptfläche 14 angeordnet ist. Weiterhin umfasst die erste Kontaktschicht mehrere Kontaktstege 12, die von der Kontaktfläche 11 aus in radialer Richtung zum Rand der Dünnfilm-LED hin verlaufen. Diese Kontaktstege 12 sind zumindest teilweise durch weitere rahmenförmige Kontaktstege 13, welche die Kontaktfläche 11 einschließen, miteinander verbunden.

Die rahmenförmigen Kontaktstege 13 können wie dargestellt als ineinander geschachtelte Quadrate oder Rechtecke ausgeführt sein. Alternativ wären beispielsweise auch kreisförmige Rahmen oder Rahmen in Form regelmäßiger Vielecke möglich, wobei bevorzugt die rahmenförmigen Kontaktstege 13 konzentrisch angeordnet sind, das heißt einen gemeinsamen Mittelpunkt aufweisen, in dem bevorzugt die Kontaktfläche 11 angeordnet ist. Die Anzahl der rahmenförmigen Kontaktstege beträgt bevorzugt 1, 2 oder 3. Die erste Kontaktschicht, die die Kontaktfläche 11 und die Kontaktstege 12, 13 umfasst, ist bevorzugt aus einem Metall, insbesondere aus Aluminium, ausgebildet.

An die dem Träger 2 zugewandte Seite der Halbleiterschichtenfolge 16 der Dünnfilm-LED grenzt eine zweite Kontaktschicht 5, die bevorzugt einen ohmschen Kontakt zur angrenzenden Halbleiterschicht 6 herstellt, an. Die zweite Kontaktschicht 5 enthält vorzugsweise ein Metall wie zum Beispiel Aluminium, Silber oder Gold. Im Fall einer p-dotierten an die zweite Kontaktschicht 5 angrenzenden Halbleiterschicht 6 ist insbesondere Silber ein geeignetes Material für die zweite Kontaktschicht 5, da Silber einen guten ohmschen Kontakt zu p-dotierten Nitridverbindungshalbleitern herstellt.

Vorzugsweise ist die zweite Kontaktschicht 5 eine die emittierte Strahlung reflektierende Schicht. Dies hat den Vorteil, dass elektromagnetische Strahlung, die von der aktiven Schicht 7 in Richtung des Trägers 2 emittiert wird, zumindest zum Teil zur Hauptfläche 14 hin reflektiert und dort aus der Dünnfilm-LED ausgekoppelt wird. Auf diese Weise werden Absorptionsverluste, die beispielsweise innerhalb des Trägers 2 oder in der Verbindungsschicht 3 auftreten könnten, vermindert.

In einem der Kontaktfläche 11 der ersten Kontaktschicht gegenüber liegenden Bereich weist die zweite Kontaktschicht 5 bevorzugt eine Ausnehmung 18 auf. Die Größe und die Form der Ausnehmung 18 stimmen bevorzugt im wesentlichen mit der Größe und der Form der Kontaktfläche 11 überein. Da im Bereich der Ausnehmung 18 kein ohmscher Kontakt zwischen der zweiten Kontaktschicht 5 und der angrenzenden Halbleiterschicht 6 entsteht, wird der Stromfluss zwischen der ersten Kontaktschicht 11, 12, 13 auf der Hauptfläche 14 und der Elektrode 1 auf der Rückseite des Trägers 2 durch den Bereich der Ausnehmung 18 vermindert. Auf diese Weise wird der Stromfluss durch einen Bereich der aktiven Schicht 7, der zwischen der ersten Kontaktfläche 11 und der Ausnehmung 18 in der zweiten Kontaktschicht 5 angeordnet ist, vorteilhaft reduziert. Die Strahlungserzeugung in diesem Bereich der aktiven Schicht 7 ist somit vermindert, wodurch vorteilhaft die Absorption von Strahlung innerhalb der nicht-transparenten Kontaktfläche 11 zumindest teilweise reduziert wird.

Zwischen der zweiten Kontaktschicht 5 und der Verbindungsschicht 3 ist vorzugsweise eine Barriereschicht 4 enthalten. Die Barriereschicht 4 enthält beispielsweise TiWN. Durch die Barriereschicht 4 wird insbesondere eine Diffusion von Material der Verbindungsschicht 3, die beispielsweise eine Lotschicht ist, in die zweite Kontaktschicht verhindert, durch die insbesondere die Reflektion der als Spiegelschicht fungierenden zweiten Kontaktschicht 5 beeinträchtigt werden könnte.

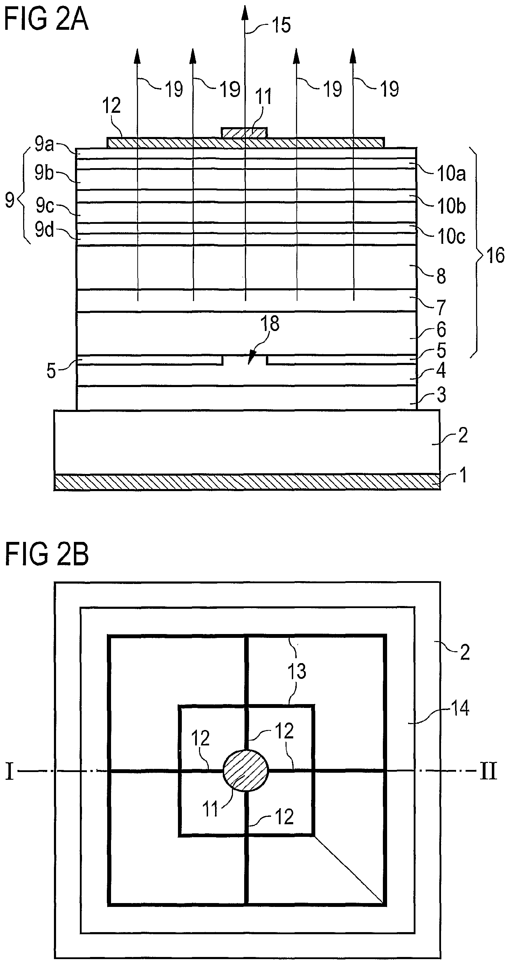

Das in der Figur 2A in einem Querschnitt und in der Figur 2B in einer Aufsicht schematisch dargestellte zweite Ausführungsbeispiel einer Dünnfilm-LED gemäß der Erfindung unterscheidet sich von dem in der Figur 1 dargestellten ersten Ausführungsbeispiel der Erfindung zum einen dadurch, dass anstelle einer einzigen Schicht drei Schichten 10a, 10b, 10c aus dem zweiten Nitridverbindungshalbleitermaterial in die Stromaufweitungsschicht 9 eingebettet sind, d.h. die Stromaufweitungsschicht 9 ist eine mehrlagige Schicht, die zum Beispiel vier GaN-Teilschichten 9a, 9b, 9c, 9d die durch drei eingebettete AlGaN-Schichten 10a, 10b, 10c voneinander getrennt sind, umfasst. Alternativ könnten auch noch weitere Schichten aus dem zweiten Nitridverbindungshalbleitermaterial in die Stromaufweitungsschicht 9 aus dem ersten Nitridverbindungshalbleitermaterial eingebettet sein.

Eine bevorzugte Anzahl der eingebetteten Schichten beträgt zwischen 1 und 5. Die mehreren Schichten 10a, 10b, 10c weisen jeweils eine Dicke von 10 nm bis 100 nm auf und müssen nicht notwendigerweise periodisch angeordnet sein. Beispielsweise sind die Schichten 10a, 10b, 10c unterschiedlich dick und/oder weisen unterschiedliche gegenseitige Abstände auf.

Durch die mehreren eingebetteten Schichten 10a, 10b, 10c aus dem zweiten Nitridverbindungshalbleitermaterial wird die Querleitfähigkeit der Stromaufweitungsschicht 9 im Vergleich zu der in Figur 1 dargestellten Ausführungsform mit einer einzelnen eingebetteten Schicht vorteilhaft weiter erhöht. Beispielsweise werden durch drei in die Stromaufweitungsschicht 9 eingebettete Schichten 10a, 10b, 10c sechs Grenzflächen zwischen dem ersten Nitridverbindungshalbleitermaterial und dem zweiten Nitridverbindungshalbleitermaterial mit der größeren elektronischen Bandlücke erzeugt. An jeder dieser Grenzflächen bildet sich jeweils ein Potentialtopf für Elektronen aus, innerhalb dessen die Elektronen eine besonders hohe Beweglichkeit aufweisen.

Ein Vorteil der Erhöhung der Querleitfähigkeit der Stromaufweitungsschicht besteht darin, dass durch das Einbetten der Schichten 10a, 10b, 10c aus dem zweiten Nitridverbindungshalbleitermaterial in die Stromaufweitungsschicht 9 die Querleitfähigkeit der Stromaufweitungsschicht 9 derart erhöht wird, dass die Anzahl der Kontaktstege, der Abstand der Kontaktstege untereinander und die von den Kontaktstegen 12, 13 und der Kontaktfläche 11 bedeckte Chipfläche vermindert werden können, ohne dass dadurch die Stromaufweitung innerhalb der Dünnfilm-LED wesentlich beeinträchtigt wird.

Wie in der Figur 2B dargestellten Aufsicht zu erkennen ist, unterscheidet sich das zweite Ausführungsbeispiel der Erfindung von dem ersten Ausführungsbeispiel der Erfindung weiterhin dadurch, dass die erste Kontaktschicht auf der Hauptfläche 14 anstelle von drei rahmenförmigen Kontaktstegen 13 nur zwei rahmenförmige Kontaktstege 13 umfasst. Durch die Erhöhung der Querleitfähigkeit der Stromaufweitungsschicht 9 kann also die Struktur der ersten Kontaktschicht 11, 12, 13 vereinfacht werden, wodurch der Herstellungsaufwand verringert und die Absorption von Strahlung innerhalb der Kontaktschicht 11, 12, 13 vermindert wird.

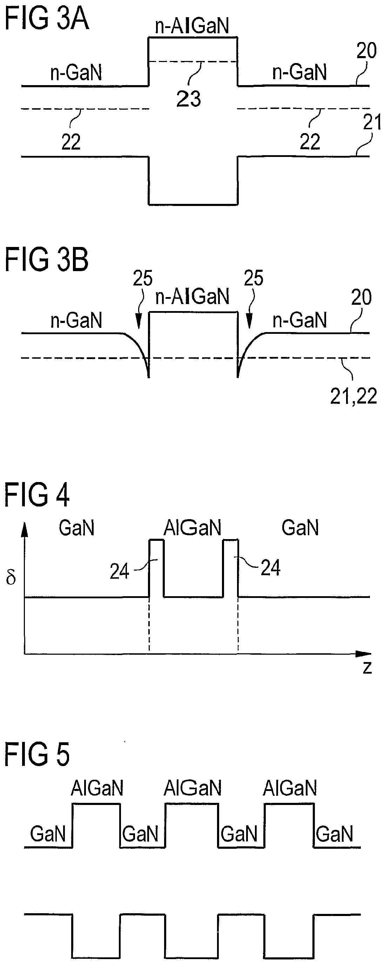

Die Erhöhung der Querleitfähigkeit durch Ausbildung eines zweidimensionalen Elektronengases wird im folgenden anhand der Figuren 3 bis 7 näher erläutert. In Figur 3A ist die elektronische Bandstruktur im Bändermodell einer Halbleiterschicht aus einem Nitridverbindungshalbleitermaterial, beispielsweise n-dotiertes GaN, in die eine Halbleiterschicht aus einem zweiten Nitridverbindungshalbleitermaterial mit einer größeren elektronischen Bandlücke, beispielsweise n-dotiertes AlGaN, eingebettet ist, schematisch dargestellt. Figur 3A zeigt schematisch den Verlauf des Leitungsbands 20, des Valenzbands 21 sowie das Fermi-Niveau 22 von GaN und das Fermi-Niveau 23 von AlGaN, wobei die Wechselwirkung zwischen den Halbleitermaterialien nicht berücksichtigt wurde. Aufgrund der größeren elektronischen Bandlücke von AlGaN im Vergleich zu GaN ist der Abstand zwischen dem Leitungsband 20 und dem Valenzband 21 in der in die GaN-Schicht eingebetteten AlGaN-Schicht größer als in der angrenzenden GaN-Schicht.

Figur 3B zeigt den Verlauf der Leitungsbandkante 21 unter Berücksichtigung der Wechselwirkung der beiden Halbleitermaterialien. Da sich die Fermi-Niveaus 22, 23 aneinander angleichen, tritt in den an die AlGaN-Schicht angrenzenden Bereichen der GaN-Schicht eine derartige Bandverbiegung auf, dass sich in diesen Bereichen jeweils ein Potentialtopf 25 für Elektronen ausbildet, in dem die Elektronen eine derart hohe Beweglichkeit aufweisen, dass sich in diesem Bereich ein zweidimensionales Elektronengas ausbildet.

In Figur 4 ist der Verlauf der Dotierstoffkonzentration δ in Abhängigkeit einer Ortskoordinate z, die senkrecht zu der Stromaufweitungsschicht, also parallel zur Hauptstrahlrichtung, verläuft, für eine erfindungsgemäße Ausführungsform der Stromaufweitungsschicht schematisch dargestellt. Bei diesem Ausführungsbeispiel ist eine AlGaN-Schicht in eine Stromaufweitungsschicht aus GaN eingebettet, wobei sowohl die GaN-Schicht als auch die AlGaN-Schicht jeweils n-dotiert sind. Die AlGaN-Schicht weist in den an die GaN-Schicht angrenzenden Bereichen 24 eine höhere Dotierstoffkonzentration als in ihrem Inneren auf (sogenannte Dotierspikes). Die Anzahl der freien Elektronen, die in den in der Figur 3B dargestellten Potentialtöpfen 25 eine hohe Beweglichkeit aufweisen, wird dadurch weiter erhöht und somit die Querleitfähigkeit weiter verbessert.

Anstatt nur eine einzige Schicht aus einem zweiten Nitridverbindungshalbleitermaterial in eine Stromaufweitungsschicht aus einem ersten Nitridverbindungshalbleitermaterial einzubetten, wie es in der Figur 3 anhand des Bändermodells verdeutlich wurde, können auch mehrere Schichten aus dem zweiten Nitridverbindungshalbleitermaterial, wie beispielsweise zuvor anhand des zweiten Ausführungsbeispiels der Erfindung erläutert wurde, eingefügt werden. Die Figur 5 verdeutlicht für diesen Fall den Verlauf des Leitungsbands 20 und des Valenzbands 21 ohne Berücksichtigung der Wechselwirkung zwischen den Halbleitermaterialien, beispielsweise GaN und AlGaN. An jeder der Grenzflächen zwischen den Halbleitermaterialien tritt unter Berücksichtigung der Wechselwirkung jeweils die im Zusammenhang mit der Figur 3B erläuterte Bandverbiegung und die entsprechende Ausbildung von Potentialtöpfen (nicht dargestellt) auf.

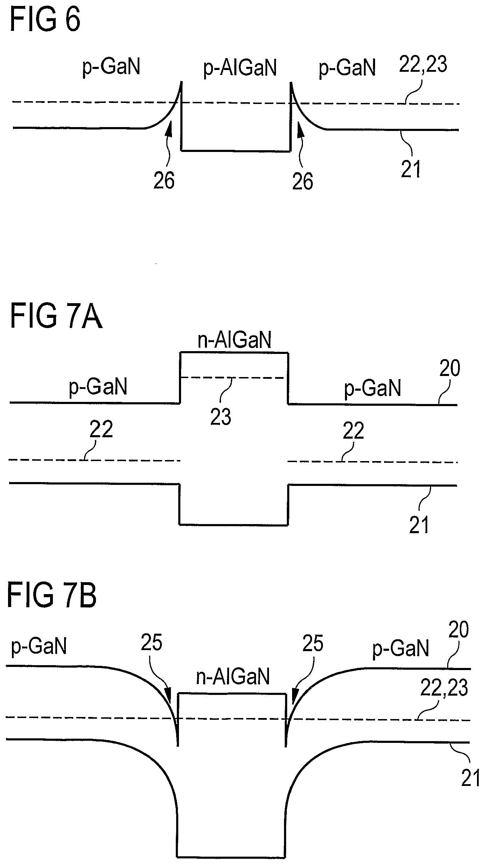

Bei dem nicht erfindungsgemäßen Beispiel der Fig. 6 sind die Stromaufweitungsschicht und die darin eingebettete Halbleiterschicht aus dem zweiten Nitridverbindungshalbleitermaterial nicht jeweils n-dotiert, sondern beide p-dotiert. Figur 6 zeigt schematisch den Verlauf der Valenzbandkante 21 für den Fall einer p-dotierten AlGaN-Schicht, die in eine p-dotierte GaN-Schicht eingebettet ist. In diesem Fall tritt an den Grenzflächen jeweils eine Bandverbiegung auf, die jeweils Potentialtöpfe 26 für Löcher darstellen. Auf diese Weise kann in den Grenzflächenbereichen jeweils ein zweidimensionales Löchergas erzeugt werden.

Bei einem weiteren nicht erfindungsgemäßen Beispiel wird zur Erzeugung eines zweidimensionalen Elektronengases innerhalb einer p-dotierten Stromaufweitungsschicht, beispielsweise p-GaN, eine n-dotierte Schicht, beispielsweise n-AlGaN, die eine größeren elektronischen Bandlücke als die p-dotierte Schicht aufweist, in die Stromaufweitungsschicht eingebettet. Das ungestörte Bändermodell dieser Ausführungsform ist schematisch in der Figur 7A und das Bändermodell unter Berücksichtigung der Wechselwirkung der Halbleiterschichten in der Figur 7B dargestellt. In Analogie zu dem in der Figur 3B dargestellten Beispiel, bei dem sowohl die GaN-Schicht als auch die eingebettete AlGaN-Schicht jeweils n-dotiert sind, bildet sich auch in diesem Fall an der Grenzfläche zwischen dem p-dotierten GaN und dem n-dotierten AlGaN aufgrund der Bandverbiegung an den Halbleiter-Halbleiter-Grenzflächen jeweils ein Potentialtopf 25 für Elektronen aus, indem sich ein zweidimensionales Elektronengas mit erhöhter Querleitfähigkeit ausbildet.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Dünnfilm-LED mit einer aktiven Schicht (7), die elektromagnetische Strahlung (19) in eine Hauptstrahlungsrichtung (15) emittiert, einer der aktiven Schicht (7) in der Hauptstrahlungsrichtung (15) nachfolgenden Stromaufweitungsschicht (9) aus einem ersten Nitridverbindungshalbleitermaterial, einer Hauptfläche (14), durch welche die in der Hauptstrahlungsrichtung (15) emittierte Strahlung (19) ausgekoppelt wird, und einer ersten Kontaktschicht (11, 12, 13), die auf der Hauptfläche (14) angeordnet ist,
**dadurch gekennzeichnet, dass**
die Querleitfähigkeit der Stromaufweitungsschicht (9) durch Ausbildung eines zweidimensionalen Elektronengases erhöht ist, wobei zur Ausbildung des zweidimensionalen Elektronengases in der Stromaufweitungsschicht (9) mindestens eine Schicht (10) aus einem zweiten Nitridverbindungshalbleitermaterial, das eine größere elektronische Bandlücke als das erste Nitridverbindungshalbleitermaterial aufweist, in die Stromaufweitungsschicht (9) eingebettet ist, wobei
- das erste und das zweite Nitridverbindungshalbleitermaterial jeweils n-dotiert sind, und
- die Dotierstoffkonzentration in der mindestens einen Schicht (10) aus dem zweiten Nitridverbindungshalbleitermaterial in den an die Stromaufweitungsschicht (9) angrenzenden Bereichen höher ist als in einem zentralen Bereich der Schicht (10).

2. Dünnfilm-LED nach Anspruch 1,
**dadurch gekennzeichnet, dass** mehrere Schichten (10a, 10b, 10c) aus dem zweiten Nitridverbindungshalbleitermaterial in die Stromaufweitungsschicht (9) eingebettet sind.

3. Dünnfilm-LED nach Anspruch 2,
**dadurch gekennzeichnet, dass**
die Anzahl der Schichten (10a, 10b, 10c) aus dem zweiten Nitridverbindungshalbleitermaterial zwischen einschließlich 1 und einschließlich 5 beträgt.

4. Dünnfilm-LED nach einem der Ansprüche 1 bis 3,
**dadurch gekennzeichnet, dass**
die mindestens eine Schicht (10) aus dem zweiten Nitridverbindungshalbleitermaterial eine Dicke von 10 nm bis 100 nm aufweist.

5. Dünnfilm-LED nach einem der Ansprüche 1 bis 4,
**dadurch gekennzeichnet, dass**
das erste Nitridverbindungshalbleitermaterial GaN ist.

6. Dünnfilm-LED nach einem der Ansprüche 1 bis 5,
**dadurch gekennzeichnet, dass**
das zweite Nitridverbindungshalbleitermaterial AlₓGa₁₋ₓN mit 0,1 ≤ x ≤ 0,2 ist.

7. Dünnfilm-LED nach einem der vorhergehenden Ansprüche, **dadurch gekennzeichnet, dass**
die aktive Schicht (7) InₓAl_{y}Ga_{1-x-y}N mit 0 ≤ x ≤ 1, 0 ≤ y ≤ 1 und x + y ≤1, aufweist.

8. Dünnfilm-LED nach einem der vorhergehenden Ansprüche, **dadurch gekennzeichnet, dass**
zumindest eine Kantenlänge der Hauptfläche (14) 400 µm oder mehr beträgt.

9. Dünnfilm-LED nach Anspruch 8,
**dadurch gekennzeichnet, dass**
zumindest eine Kantenlänge der Hauptfläche (14) 800 µm oder mehr beträgt.

10. Dünnfilm-LED nach einem der vorhergehenden Ansprüche, **dadurch gekennzeichnet, dass**
ein Betrieb der Dünnfilm-LED mit einer Stromstärke von 300 mA oder mehr vorgesehen ist.

11. Dünnfilm-LED nach einem der vorhergehenden Ansprüche, **dadurch gekennzeichnet, dass**
die erste Kontaktschicht (11, 12, 13) kein Aluminium umfasst.

12. Dünnfilm-LED nach einem der vorhergehenden Ansprüche, **dadurch gekennzeichnet, dass**
weniger als 15% der Gesamtfläche der Hauptfläche (14) von der ersten Kontaktschicht (11, 12, 13) bedeckt sind.

13. Dünnfilm-LED nach einem der vorhergehenden Ansprüche, **dadurch gekennzeichnet, dass**
die erste Kontaktschicht (11, 12, 13) eine laterale Struktur aufweist, die eine Kontaktfläche (11) und mehrere Kontaktstege (12, 13) umfasst.

14. Dünnfilm-LED nach Anspruch 13,
**dadurch gekennzeichnet, dass**
die Kontaktfläche (11) von mindestens einem rahmenförmigen Kontaktsteg (13) umgeben ist, wobei der rahmenförmige Kontaktsteg (13) durch mindestens einen weiteren Kontaktsteg (12) mit der Kontaktfläche verbunden ist.

15. Dünnfilm-LED nach Anspruch 14,
**dadurch gekennzeichnet, dass**
der rahmenförmige Kontaktsteg (13) eine quadratische, rechteckige oder kreisförmige Form aufweist.

16. Dünnfilm-LED nach Anspruch 14 oder 15,
**dadurch gekennzeichnet, dass**
die Anzahl der rahmenförmigen Kontaktstege (13) eins, zwei oder drei beträgt.

17. Dünnfilm-LED nach einem der vorhergehenden Ansprüche, **dadurch gekennzeichnet, dass**
auf einer der ersten Kontaktschicht (11, 12, 13) gegenüberliegenden Seite der aktiven Schicht (7) eine die emittierte Strahlung reflektierende zweite Kontaktschicht (5) vorgesehen ist, wobei die erste Kontaktschicht (11, 12, 13) eine Kontaktfläche (11) aufweist und die zweite Kontaktschicht (5) in einem der Kontaktfläche (11) gegenüberliegenden Bereich eine Aussparung (18) aufweist.

## Claims

1. Thin-film LED comprising an active layer (7), which emits electromagnetic radiation (19) in a main radiation direction (15), a current expansion layer (9), which is disposed downstream of the active layer (7) in the main radiation direction (15) and is made of a first nitride compound semiconductor material, a main area (14), through which the radiation (19) emitted in the main radiation direction (15) is coupled out, and a first contact layer (11, 12, 13) arranged on the main area (14),
**characterized in that**
the transverse conductivity of the current expansion layer (9) is increased by formation of a two-dimensional electron gas, wherein in order to form the two-dimensional electron gas in the current expansion layer (9), at least one layer (10) made of a second nitride compound semiconductor material having a larger electronic band gap than the first nitride compound semiconductor material is embedded in the current expansion layer (9), wherein
- the first and second nitride compound semiconductor materials are in each case n-doped, and
- the dopant concentration in the at least one layer (10) made of the second nitride compound semiconductor material is higher in the regions adjoining the current expansion layer (9) than in a central region of the layer (10).

2. Thin-film LED according to Claim 1, **characterized in that**
a plurality of layers (10a, 10b, 10c) made of the second nitride compound semiconductor material are embedded in the current expansion layer (9).

3. Thin-film LED according to Claim 2, **characterized in that**
the number of layers (10a, 10b, 10c) made of the second nitride compound semiconductor material is between 1 and 5 inclusive.

4. Thin-film LED according to one of Claims 1 to 3, **characterized in that**
the at least one layer (10) made of the second nitride compound semiconductor material has a thickness of 10 nm to 100 nm.

5. Thin-film LED according to one of Claims 1 to 4, **characterized in that**
the first nitride compound semiconductor material is GaN.

6. Thin-film LED according to one of Claims 1 to 5, **characterized in that**
the second nitride compound semiconductor material is AlₓGa₁₋ₓN where 0.1 ≤ x ≤ 0.2.

7. Thin-film LED according to one of the preceding claims,
**characterized in that**
the active layer (7) has InₓAl_{y}Ga_{1-x-y}N where 0 ≤ x ≤ 1, 0 ≤ y ≤ 1 and x + y ≤ 1.

8. Thin-film LED according to one of the preceding claims,
**characterized in that**
at least one edge length of the main area (14) is 400 µm or more.

9. Thin-film LED according to Claim 8, **characterized in that**
at least one edge length of the main area (14) is 800 µm or more.

10. Thin-film LED according to one of the preceding claims,
**characterized in that**
operation of the thin-film LED with a current intensity of 300 mA or more is provided.

11. Thin-film LED according to one of the preceding claims,
**characterized in that**
the first contact layer (11, 12, 13) comprises no aluminum.

12. Thin-film LED according to one of the preceding claims,
**characterized in that**
less than 15% of the total area of the main area (14) is covered by the first contact layer (11, 12, 13).

13. Thin-film LED according to one of the preceding claims,
**characterized in that**
the first contact layer (11, 12, 13) has a lateral structure comprising a contact area (11) and a plurality of contact webs (12, 13).

14. Thin-film LED according to Claim 13, **characterized in that**
the contact area (11) is surrounded by at least one frame-type contact web (13), the frame-type contact web (13) being connected to the contact area by means of at least one further contact web (12).

15. Thin-film LED according to Claim 14, **characterized in that**
the frame-type contact web (13) has a square, rectangular or circular form.

16. Thin-film LED according to Claim 14 or 15, **characterized in that**
the number of frame-type contact webs (13) is one, two or three.

17. Thin-film LED according to one of the preceding claims,
**characterized in that**
a second contact layer (5), which reflects the emitted radiation, is provided on a side of the active layer (7) opposite to the first contact layer (11, 12, 13), the first contact layer (11, 12, 13) having a contact area (11) and the second contact layer (5) having a cutout (18) in a region opposite the contact area (11).

## Revendications

1. LED à film mince comprenant une couche active (7) qui émet un rayonnement électromagnétique (19) dans une direction de rayonnement principale (15), une couche d'élargissement du courant (9) constituée d'un premier matériau semiconducteur à base d'un composé de nitrure à la suite de la couche active (7) dans la direction de rayonnement principale (15), une surface principale (14) à travers laquelle est découplé le rayonnement (19) émis dans la direction de rayonnement principale (15), et une première couche de contact (11, 12, 13) qui est disposée sur la surface principale (14),
**caractérisée en ce que**
la conductivité transversale de la couche d'élargissement du courant (9) est augmentée en formant un gaz d'électrons bidimensionnel, au moins une couche (10) constituée d'un deuxième matériau semiconducteur à base d'un composé de nitrure, lequel présente une bande interdite électronique plus grande que le premier matériau semiconducteur à base d'un composé de nitrure, étant enrobée dans la couche d'élargissement du courant (9) en vue de former le gaz d'électrons bidimensionnel dans la couche d'élargissement du courant (9),
- le premier et le deuxième matériau semiconducteur à base d'un composé de nitrure étant respectivement dopés N et
- la concentration de substance dopante dans l'au moins une couche (10) constituée du deuxième matériau semiconducteur à base d'un composé de nitrure dans les zones adjacentes à la couche d'élargissement du courant (9) étant plus élevée que dans une zone centrale de la couche (10).

2. LED à film mince selon la revendication 1, **caractérisée en ce que** plusieurs couches (10a, 10b, 10c) constituées du deuxième matériau semiconducteur à base d'un composé de nitrure sont enrobées dans la couche d'élargissement du courant (9).

3. LED à film mince selon la revendication 2, **caractérisée en ce que** le nombre de couches (10a, 10b, 10c) constituées du deuxième matériau semiconducteur à base d'un composé de nitrure est compris entre 1 inclus et 5 inclus.

4. LED à film mince selon l'une des revendications 1 à 3, **caractérisée en ce que** l'au moins une couche (10) constituée du deuxième matériau semiconducteur à base d'un composé de nitrure présente une épaisseur de 10 nm à 100 nm.

5. LED à film mince selon l'une des revendications 1 à 4, **caractérisée en ce que** le premier matériau semiconducteur à base d'un composé de nitrure est du GaN.

6. LED à film mince selon l'une des revendications 1 à 5, **caractérisée en ce que** le deuxième matériau semiconducteur à base d'un composé de nitrure est de l'AlₓGa₁₋ₓN, avec 0,1 ≤ x ≤ 0,2.

7. LED à film mince selon l'une des revendications précédentes, **caractérisée en ce que** la couche active (7) présente de l'InₓAl_{y}Ga_{1-x-y}N, avec 0 ≤ x ≤ 1, 0 ≤ y ≤ 1 et x + y ≤ 1.

8. LED à film mince selon l'une des revendications précédentes, **caractérisée en ce qu'**au moins une longueur de bord de la surface principale (14) est égale ou supérieure à 400 µm.

9. LED à film mince selon la revendication 8, **caractérisée en ce qu'**au moins une longueur de bord de la surface principale (14) est égale ou supérieure à 800 µm.

10. LED à film mince selon l'une des revendications précédentes, **caractérisée en ce qu'**un fonctionnement de la LED à film mince est prévu avec une intensité de courant égale ou supérieure à 300 mA.

11. LED à film mince selon l'une des revendications précédentes, **caractérisée en ce que** la première couche de contact (11, 12, 13) ne comprend pas d'aluminium.

12. LED à film mince selon l'une des revendications précédentes, **caractérisée en ce que** moins de 15 % de la surface totale de la surface principale (14) sont recouverts par la première couche de contact (11, 12, 13).

13. LED à film mince selon l'une des revendications précédentes, **caractérisée en ce que** la première couche de contact (11, 12, 13) possède une structure latérale qui comprend une surface de contact (11) et plusieurs nervures de contact (12, 13).

14. LED à film mince selon la revendication 13, **caractérisée en ce que** la surface de contact (11) est entourée par au moins une nervure de contact (13) en forme de cadre, la nervure de contact (13) en forme de cadre étant reliée à la surface de contact par au moins une nervure de contact (12) supplémentaire.

15. LED à film mince selon la revendication 14, **caractérisée en ce que** la nervure de contact (13) en forme de cadre présente une forme carrée, rectangulaire ou circulaire.

16. LED à film mince selon la revendication 14 ou 15, **caractérisée en ce que** le nombre de nervures de contact (13) en forme de cadre est d'un, de deux ou de trois.

17. LED à film mince selon l'une des revendications précédentes, **caractérisée en ce qu'**une deuxième couche de contact (5) réfléchissant le rayonnement émis se trouve sur le côté de la couche active (7) à l'opposé de la première couche de contact (11, 12, 13), la première couche de contact (11, 12, 13) possédant une surface de contact (11) et la deuxième couche de contact (5) possédant une cavité (18) dans une zone opposée à la surface de contact (11).
